# EUROPÄISCHE PATENTSCHRIFT

(11) **EP 1 169 145 B1**
(45) Veröffentlichungstag und Bekanntmachung des Hinweises auf die Patenterteilung: **01.09.2004**
(21) Anmeldenummer: 00922525.1
(22) Anmeldetag: 16.03.2000
(51) Int. Cl.: B08B 3/10, H01L 21/304

(54) **VERFAHREN UND VORRICHTUNG ZUM REINIGEN VON SUBSTRATEN**
METHOD AND DEVICE FOR CLEANING SUBSTRATES
PROCEDE ET DISPOSITIF DE NETTOYAGE DE SUBSTRATS

(30) Priorität: 12.04.1999 DE 19916345
(43) Veröffentlichungstag der Anmeldung: 09.01.2002
(73) Patentinhaber: STEAG MicroTech GmbH, 72124 Pliezhausen (DE)
(72) Erfinder: LOHMÜLLER, Jürgen, D-72762 Reutlingen (DE)
(74) Vertreter: Wagner, Karl H., Dipl.-Ing.
(86) Internationale Anmeldenummer: PCT/EP2000/002339
(87) Internationale Veröffentlichungsnummer: WO 2000/061306

(56) Entgegenhaltungen:
- WO-A-98/14985
- US-A- 5 558 110
- US-A- 5 868 866
- PATENT ABSTRACTS OF JAPAN vol. 016, no. 297 (E-1226), 30. Juni 1992 (1992-06-30) -& JP 04 079326 A (MITSUBISHI ELECTRIC CORP), 12. März 1992 (1992-03-12)
- PATENT ABSTRACTS OF JAPAN vol. 015, no. 118 (E-1048), 22. März 1991 (1991-03-22) & JP 03 008326 A (MITSUBISHI ELECTRIC CORP), 16. Januar 1991 (1991-01-16)
- PATENT ABSTRACTS OF JAPAN vol. 017, no. 206 (M-1400), 22. April 1993 (1993-04-22) & JP 04 348871 A (MITSUBISHI HEAVY IND LTD), 3. Dezember 1992 (1992-12-03)
- PATENT ABSTRACTS OF JAPAN vol. 1996, no. 02, 29. Februar 1996 (1996-02-29) -& JP 07 256222 A (NIKON CORP), 9. Oktober 1995 (1995-10-09)
- PATENT ABSTRACTS OF JAPAN vol. 016, no. 192 (E-1199), 11. Mai 1992 (1992-05-11) & JP 04 026121 A (MITSUBISHI ELECTRIC CORP), 29. Januar 1992 (1992-01-29)

## Beschreibung

Die vorliegende Erfindung bezieht sich auf ein Verfahren und eine Vorrichtung zum Reinigen von Substraten, insbesondere Halbleiterwafem, bei dem vor und/oder während der Reinigung eine Flüssigkeit auf das Substrat aufgebracht wird, gemäß dem Oberbegriff des Patentanspruchs 1 und gemäß dem Oberbegriff des Patentanspruchs 13.

Ein Verfahren und eine Vorrichtung dieser Art ist beispielweise aus der JP-A-04-026 121 bekannt.

Eine weitere Vorrichtung vergleichbarer Art ist beispielsweise aus der WO 96/10463 bekannt. Bei dieser Vorrichtung wird ein Wasserfilm auf die zu reinigende Oberfläche eines Substrats aufgebracht und gleichzeitig oder anschließend Wasserdampf über eine Düse gezielt auf die zu reinigende Oberfläche geleitet. Der Wasserdampf kühlt in dem Wasserfilm schnell ab, wobei kleine Wasserdampfblasen implodieren und dabei einen Impuls in dem Wasserfilm erzeugen, der Partikel von der zu reinigenden Oberfläche löst.

Bei dieser bekannten Vorrichtung können stark anhaftende Partikel an der zu reinigenden Oberfläche verbleiben, wenn der Impuls nicht ausreicht, diese abzulösen. Darüber hinaus benötigt die Vorrichtung einen Dampfgenerator, der die Vorrichtung insgesamt vergrößert. Ferner kommt der Wasserdampf innerhalb des Dampfgenerators und den danach angeordneten, medienführenden Teilen mit Metall in Kontakt, so daß eine Gefahr der Verunreinigung der zu reinigenden Substrate durch Metallionen besteht.

Ferner sei auf die US-A-5, 651, 834 hingewiesen, die ein Verfahren zum Reinigen gedruckter Schaltungsplatten zeigt. Bei diesem Verfahren wird ein dünner Wasserfilm auf eine zu reinigende Seite der Schaltungsplatte aufgebracht. Anschließend wird die zu reinigende Seite der Schaltungsplatte mit Eiskristallen beschossen, die durch den Wasserfilm hindurchtreten und auf die Oberfläche der Schaltungsplatte auftreffen, um diese zu reinigen. Der Wasserfilm besitzt die Funktion, während des Beschusses mit Eiskristallen auftretende elektrische Ladungen abzuleiten, damit diese die gedruckten Schaltungen nicht beschädigen. Eine derartige Vorrichtung ist ebenfalls aus der JP-A-04 026 121 sowie aus der JP-A-07 256 222 bekannt.

Ausgehend von der bekannten Vorrichtung liegt der vorliegenden Erfindung die Aufgabe zugrunde, eine Vorrichtung und ein Verfahren vorzusehen, welche bzw. welches auf einfache und kostengünstige Weise eine zuverlässige Reinigung von Substraten ohne die Gefahr einer Beschädigung derselben erlaubt.

Die Aufgabe wird erfindungsgemäß bei einem Verfahren zum Reinigen von Substraten, insbesondere Halbleiterwafern, bei dem vor und/oder während der Reinigung eine Flüssigkeit auf das Substrat aufgebracht wird, und Eiskristalle in die auf dem Substrat befindliche Flüssigkeit eingebracht werden dadurch gelöst, dass die Flüssigkeit eine wesentlich höhere Temperatur als die Eiskristalle besitzt und die Eindringtiefe der Eiskristalle in die Flüssigkeit derart gesteuert wird, dass die Eiskristalle nicht auf die zu reinigende Oberfläche des Substrats auftreffen, um eine gezielte Impulserzeugung und somit eine gezielte Reinigung zu erreichen. Durch Steuern der Eindringtiefe der Eiskristalle wird verhindert, dass die Eiskristalle auf die zu reinigende Oberfläche des Substrats auftreffen und diese dabei beschädigen, da die Eiskristalle vor dem Auftreffen in den Gaszustand übergehen. Aufgrund des wesentlichen Temperaturunterschieds der Eiskristalle zur Temperatur der Flüssigkeit gehen diese explosionsartig in den Gaszustand über. Der dabei erzeugte Impuls, der wesentlich größer ist als der Impuls, der durch das Implodieren kleiner Wasserdampfblasen erzeugt wird, löst Partikel von der Oberfläche des zu reinigenden Substrats. Zur Durchführung des erfindungsgemäßen Verfahrens ist ausschließlich eine Flüssigkeits-Zuteitung sowie eine Zuleitung für ein unter hohem Druck stehendes Gas notwendig, so daß die zur Durchführung des Verfahrens benötigte Vorrichtung eine geringe Größe aufweist. Insbesondere bei der Reinigung von Halbleiterwafern, welche in der Regel in Reinsträumen erfolgt, ist es wichtig, möglichst Vorrichtung mit kleinen Abmessungen zu verwenden, da Reinsträume sowohl bei der Herstellung als auch beim Betrieb erhebliche Kosten hervorrufen. Da ausschließlich eine Zuleitung für die Flüssigkeit und ein unter Hochdruck stehendes Gas benötigt werden, können die medienführenden Teile ohne Metall auskommen, so daß die Gefahr einer Verunreinigung des Substrats mit Metallionen ausgeschlossen werden kann. Darüber hinaus ist die Größe und Temperatur der Eiskristalle, und somit die Größe des erzeugten Impulses, wenn die Kristalle in den Gaszustand übergehen, leicht zu steuern, wodurch sich insgesamt eine gute Steuerung des Reinigungsprozesses ergibt.

Um die Größe des an die Oberfläche des Substrats gelangenden impulses zu steuern, wird vorteilhafterweise die Dicke einer Flüssigkeitsschicht auf dem Substrat und/oder die Temperatur der Flüssigkeit gesteuert. Durch die Dicke der Flüssigkeitsschicht kann der Abstand zwischen dem Ursprung des Impulses und der Oberfläche des Substrats und somit die Stärke des Impulses an der Oberfläche des Substrats eingestellt werden. Über die Steuerung der Flüssigkeitstemperatur kann die Heftigkeit des Übergangs der Eiskristalle in den Gaszustand und somit die Größe des Impulses verändert werden.

Bei einer weiteren Ausführungsform der Erfindung wird die Größe und/oder Temperatur der Eiskristalle gesteuert, welche beide die Impulskraft mitbestimmen, die beim Übergang der Eiskristalle in den Gaszustand erzeugt wird.

Gemäß einer bevorzugten Ausführungsform der Erfindung werden die Eiskristalle vorzugsweise schräg auf das Substrat gerichtet, um eine Reinigungsrichtung vorzugeben. Vorteilhafterweise werden die Eiskristalle in wenigstens einer Eis-Düse erzeugt, die auf das Substrat gerichtet ist. Dabei wird während der Reinigung vorteilhafterweise eine Relativbewegung zwischen der Eis-Düse und dem Substrat erzeugt, um eine Reinigung der gesamten Substratoberfläche sicherzustellen. Bei einer Ausführungsform wird das Substrat und/oder die Eis-Düse linear bewegt. Vorteilhafterweise wird das Substrat ferner gedreht, damit gelöste Partikel durch die durch die Drehung entstehende Zentrifugalkraft aus dem Bereich des Wafers herausbewegt werden.

Bei einer weiteren Ausführungsform der Erfindung ist das Substrat während der Reinigung bezüglich der Horizontalen geneigt, um ein ständiges Abfließen des Flüssigkeitsfilms und der gelösten Partikel zu gewährleisten.

Vorteilhafterweise besteht die Flüssigkeit aus deionisiertem Wasser, und die Eiskristalle bestehen vorzugsweise aus CO₂, da CO₂ bei Normaldruck sublimiert.

Die der Erfindung zugrundeliegende Aufgabe wird bei einer Vorrichtung zum Reinigen von Substraten, insbesondere Halbleiterwafern, mit einer Einrichtung zum Aufbringen einer Flüssigkeit auf das Substrat und einer Einrichtung zum Einleiten von Eiskristallen in die Flüssigkeit dadurch gelöst, daß die Flüssigkeit eine wesentlich höhere Temperatur als die Eiskristalle besitzt und eine Steuereinrichtung zum Steuern der Eindringtiefe der Eiskristalle in die Flüssigkeit vorgesehen ist, die derart steuerbar ist, dass die Eiskristalle nicht auf die zu reinigende Oberfläche des Substrats auftreffen.

Bei einer derartigen Vorrichtung ergeben sich die schon oben genannten Vorteile.

Zweckmäßige Weiterbildungen der Erfindung nach Anspruch 13 sind Gegenstand der betreffenden abhängigen Ansprüche 14 bis 25.

Vorteilhafterweise weist die Vorrichtung wenigstens eine Düse zum Aufbringen der Flüssigkeit auf, welche vorzugsweise als Breitschlitzdüse mit einer Breite, die größer oder gleich der Breite des Substrats ist, ausgebildet ist. Durch die Verwendung einer derartigen Breitschlitzdüse kann auf einfache Weise sichergestellt werden, daß die gesamte, zu reinigende Substratoberfläche mit der Flüssigkeit bedeckt ist. Vorzugsweise weist die Vorrichtung femer eine Einrichtung zum Temperieren der Flüssigkeit auf, wodurch die schon oben beschriebenen Vorteile erreicht werden.

Die Erfindung wird nachstehend anhand bevorzugter Ausführungsbeispiele unter Bezugnahme auf die Figuren näher erläutert. Es zeigen:
- Fig. 1: eine schematische Seitenansicht einer Substrat-Reinigungsvorrichtung gemäß einem ersten Ausführungsbeispiel der Erfindung;
- Fig. 2: eine schematische Seitenansicht gemäß einer weiteren Ausführungsform der Erfindung;
- Fig. 3: eine schematische Seitenansicht einer weiteren Ausführungsform der Erfindung;
- Fig. 4: eine Draufsicht auf das Ausführungsbeispiel gemäß Fig. 3.

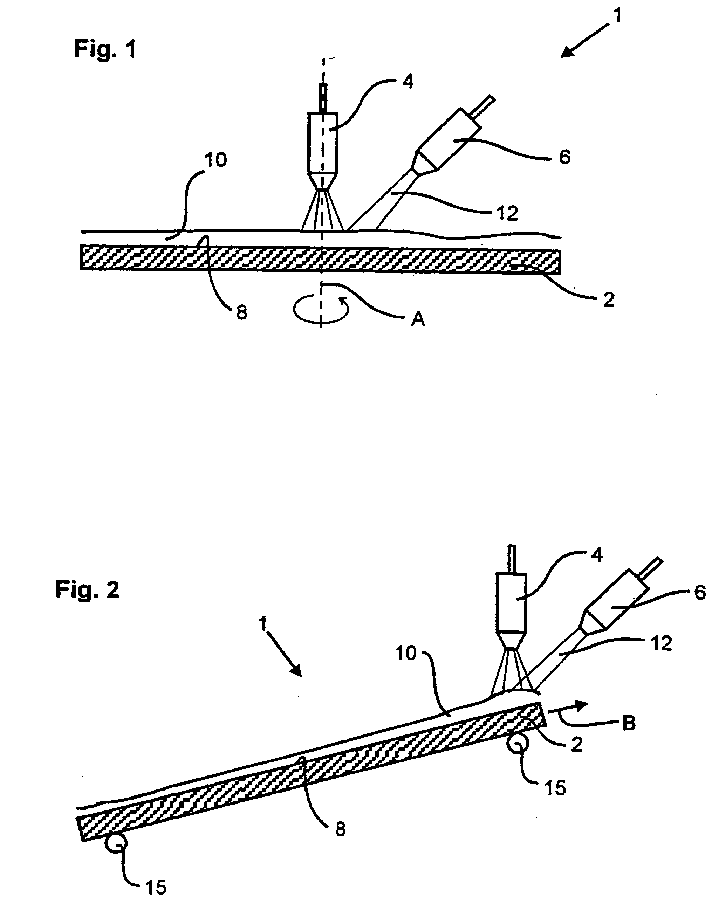

Figur 1 zeigt eine schematische Seitenansicht einer Reinigungsvorrichtung 1 für Halbleiterwafer 2. Die Reinigungsvorrichtung 1 weist eine Flüssigkeitsdüse 4 sowie eine Eis-Düse 6 auf, die auf eine zu reinigende Oberfläche 8 des Substrats 2 gerichtet sind. Das Substrat 2 wird in der Reinigungsvorrichtung 1 über eine nicht näher dargestellte Vorrichtung gehalten und um eine Mittelachse A gedreht.

Über die Düse 4 wird eine Flüssigkeitsschicht 10, die beispielsweise aus DI-Wasser (deionisiertem Wasser) besteht, mittig auf den Wafer 2 aufgebracht. Durch die Drehung des Wafers 2 strömt die Wasserschicht radial nach außen und bildet einen gleichmäßigen Film auf der zu reinigenden Oberfläche 8 des Wafers 2.

Über die Eis-Düse 6 wird ein Strahl 12 aus Eiskristallen auf die Wasserschicht 10 gerichtet und in diese eingeleitet. Die Eiskristalle werden in bekannter Art und Weise in der Eis-Düse 6 durch plötzliche Expansion eines unter Druck stehenden Gases oder einer Flüssigkeit und der damit verbundenen Abkühlung erreicht. Die Eiskristalle bestehen aus einer beliebigen, geeigneten Substanz in einem gefrorenen Zustand.

Die Temperatur der Eiskristalle, welche beispielsweise aus CO₂ bestehen, ist wesentlich tiefer als die des Wassers in der Schicht 10. Wenn die Eiskristalle in die Wasserschicht 10 eindringen, gehen sie aufgrund des Temperaturunterschieds explosionsartig in den Gaszustand über. Dabei wird ein Impuls in dem Wasserfilm erzeugt, welcher Partikel von der zu reinigenden Oberfläche 8 des Substrats 2 löst. Um eine gute Reinigung der gesamten Oberfläche 8 des Wafers 2 zu gewährleisten, wird die Eis-Düse 6 bezüglich des Substrats 2 radial von der Mittelachse A zu einer Kante des Wafers bewegt. In Kombination mit der Drehung des Wafers 2 wird die Reinigung der gesamten Oberfläche 8 des Wafers 2 sichergestellt.

Alternativ zu einer Bewegung der Düse 6 könnte auch der Wafer 2 bei fortlaufender Drehung linear zu der Eis-Düse 6 bewegt werden.

Figur 2 zeigt eine alternative Ausführungsform der Erfindung, wobei in Figur 2 dieselben Bezugszeichen verwendet werden, um dieselben oder äquivalente Bauteile zu bezeichnen.

Die Reinigungsvorrichtung 1 gemäß Figur 2 weist wiederum eine Flüssigkeitsdüse 4 sowie eine Eis-Düse 6 auf, die auf eine zu reinigende Oberfläche 8 eines Wafers 2 gerichtet sind. Der Wafer 2 wird über eine Vielzahl von Rollen 15, von denen zwei gezeigt sind, derart gehalten, daß der Wafer 2 bezüglich einer Horizontalen geneigt ist. Durch die Neigung des Wafers 2 fließt der auf die zu reinigende Oberfläche 8 aufgebrachte Wasserfilm 10 gemäß Figur 2 nach links ab.

Die Rollen 15, welche den Wafer 2 halten, sind drehbar und ermöglichen eine Linearbewegung des Wafers 2 in Richtung des Pfeils B. Durch diese Linearbewegung wird der Wafer 2 unter der Flüssigkeitsdüse 4 und die Eis-Düse 6 hindurchbewegt, wodurch die gesamte Oberfläche gereinigt wird. Um eine Reinigung des Wafers 2 über die gesamte Breite zu gewährleisten, sind die Flüssigkeitsdüse 4 sowie die Eis-Düse 6 jeweils als Breitschlitzdüsen ausgebildet, welche sich über die Breite des Wafers 2 hinweg erstrecken. Alternativ könnten eine Vielzahl von nebeneinander angeordneten Flüssigkeitsdüsen und Eis-Düsen mit angrenzenden oder sich überlappenden Arbeitsbereichen vorgesehen sein.

Statt, wie oben beschrieben, den Wafer 2 durch die Rollen 15 unter den Düsen 4 und 6 hindurchzubewegen, ist es auch möglich, die Düsen 4 und 6 bezüglich des Wafers 2 zu bewegen, wobei der Abstand zwischen dem Wafer 2 und der zu reinigenden Waferoberfläche 8 beibehalten werden sollte.

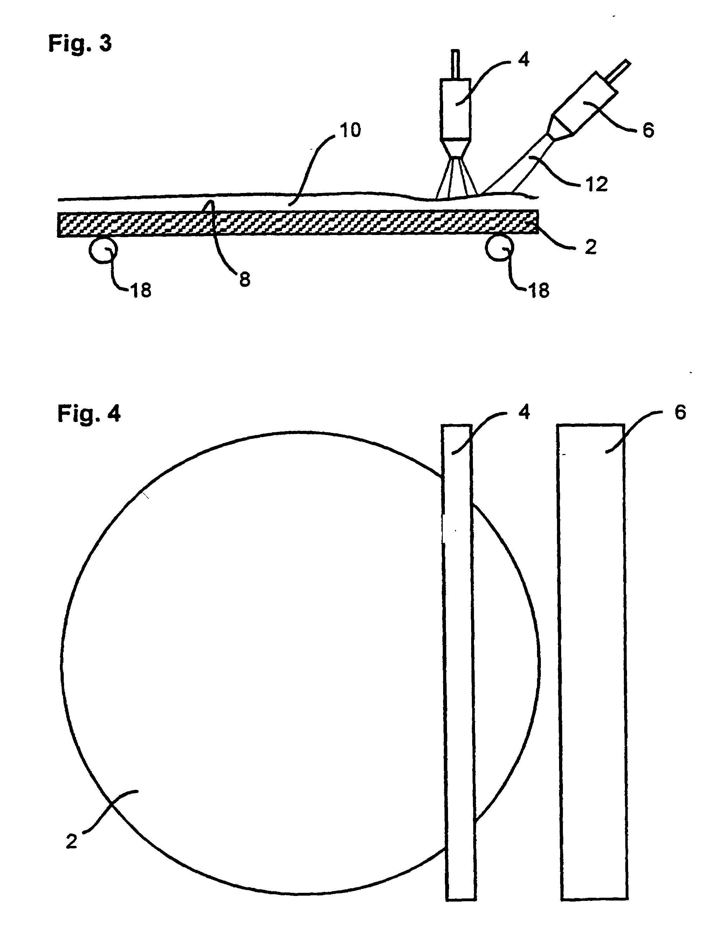

Figur 3 zeigt wiederum eine weitere Ausführungsform der Erfindung, bei der der Wafer 2 über eine Vielzahl von Rollen 18, von denen zwei gezeigt sind, in der Horizontalen gehalten werden. Wie bei dem Ausführungsbeispiel gemäß Figur 2 sind die Rollen 18 drehbar und in Lage, den Wafer 2 während der Reinigung unter den Düsen 4 und 6 hindurchzubewegen. Alternativ könnten die Rollen 18 jedoch auch feststehend ausgebildet sein, und die Düsen 4, 6 könnten sich linear über den Wafer 2 hinwegbewegen.

Figur 4 zeigt eine Draufsicht auf das Ausführungsbeispiel gemäß Figur 3, wobei zu erkennen ist, daß sowohl die Flüssigkeitsdüse 4 also auch die Eis-Düse 6 als Breitschlitzdüsen mit einer Breite, die etwas größer als die Breite des zu reinigenden Substrats 2 ist, ausgebildet sind.

Nachfolgend wird ein Reinigungsvorgang anhand des Ausführungsbeispiels gemäß Figur 1 beschrieben.

Der Wafer 2 wird über eine nicht dargestellte Handhabungsvorrichtung in die in Figur 1 gezeigte Position in der Reinigungsvorrichtung 1 gebracht. Anschließend wird über die Flüssigkeitsdüse 4 DI-Wasser mittig auf den Wafer 2 aufgebracht, und der Wafer 2 wird um die Achse A gedreht, um eine gleichmäßige Wasserschicht 10 auf dem Wafer zu erzeugen. Durch Einstellen der Drehgeschwindigkeit des Substrats und der Durchflußmenge der Düse 4 wird die Dicke der Wasserschicht 10 auf dem Substrat 2 gesteuert. Beim Erreichen einer bestimmten Schichtdicke wird über die Eis-Düse 6 ein Strahl 12 aus Eiskristallen in die Wasserschicht 10 eingeschossen. Dabei beginnt die Düse im Bereich der Mittelachse A Eiskristalle in die Wasserschicht 10 einzuschießen, und anschließend wird die Düse 6 in Richtung der Außenkante des Wafers 2 bewegt, so daß die Wasserschicht in allen Bereichen gleichmäßig mit Eiskristallen beschossen wird.

Die Größe und die Temperatur der Eiskristalle wird durch den in der Eis-Düse 6 erzeugten Druckabfall sowie eine Vorkühlung des CO₂-Gases bzw. der CO₂-Flüssigkeit gesteuert. Um die Eindringtiefe der Eiskristalle in die Wasserschicht 10 zu steuern, ist der Abstand zwischen der Eis-Düse 6 und dem Wasserfilm 10 veränderbar. Die Eis-Düse kann zum Erzeugen der Eiskristalle mehrere hintereinander angeordnete Düsen aufweisen, um eine mehrstufige Abkühlung vorzusehen.

Nachdem der Wasserfilm 10 gleichmäßig mit Eiskristallen beschossen wurde, wird zunächst der Beschuß mit Eiskristallen und anschließend die Zufuhr von DI-Wasser gestoppt. Anschließend wird der derart gereinigte Wafer 2 aus der Vorrichtung 1 entnommen.

Die Reinigung in den Vorrichtungen gemäß den Figuren 2 bis 4 läuft im wesentlichen identisch ab, wobei der Wafer 2 jedoch nicht in Drehbewegung versetzt wird. Die Vorrichtungen 1 gemäß den Figuren 2 bis 4 können als sogenannte Durchlaufstationen ausgebildet sein, in denen fortlaufend Wafer von einer Seite zugeführt, unter den Reinigungsdüsen hindurchgeführt und auf einer anderen Seite der Vorrichtung ausgebracht werden. Die Wafer können, wie in den Figuren gezeigt, über drehbare Rollen 15; 18 durch die Vorrichtung 1 hindurchtransportiert werden. Alternativ können die Wafer auch auf einem Luftkissen oder in einer Wasserströmung durch die Vorrichtung transportiert werden.

Obwohl die Vorrichtung anhand bevorzugter Ausführungsbeispiele beschrieben wurde, sei bemerkt, daß die Erfindung nicht auf die konkreten Ausführungsbeispiele beschränkt ist. Insbesondere können andere Flüssigkeiten, wie z. B. Alkohole, Spülmittel usw., in der auf dem Wafer befindlichen Flüssigkeitsschicht enthalten sein. Auch die Eiskristalle können eine unterschiedliche Zusammensetzung aufweisen. Neben der Reinigung von Halbleiterwafern eignet sich die Reinigungsvorrichtung insbesondere auch für Masken, Bauteile in der Mikromechanik, CDs usw.

Ferner ist eine beidseitige Reinigung von Substraten bei dem erfindungsgemäßen Verfahren bzw. der erfindungsgemäßen Vorrichtung möglich, obwohl die bevorzugten Ausführungsbeispiele jeweils eine einseitige Reinigung zeigen. Die beidseitige Reinigung kann dabei sequentiell oder simultan erfolgen.

## Patentansprüche

1. Verfahren zum Reinigen von Substraten, insbesondere Halbleiterwafern, bei dem vor und/oder während der Reinigung eine Flüssigkeit auf das Substrat aufgebracht wird und Eiskristalle in die auf dem Substrat befindliche Flüssigkeit eingebracht werden, **dadurch gekennzeichnet, daß** die Flüssigkeit eine wesentlich höhere Temperatur als die Eiskristalle besitzt und die Eindringtiefe der Eiskristalle in die Flüssigkeit derart gesteuert wird, daß die Eiskristalle nicht auf die zu reinigende Oberfläche des Substrats auftreffen.

2. Verfahren nach Anspruch 1, **dadurch gekennzeichnet, daß** die Dicke einer Flüssigkeitsschicht gesteuert wird.

3. Verfahren nach Anspruch 1 oder 2, **dadurch gekennzeichnet, daß** die Temperatur der Flüssigkeit gesteuert wird.

4. Verfahren nach einem der vorhergehenden Ansprüche, **dadurch gekennzeichnet, daß** die Größe und/oder Temperatur der Eiskristalle gesteuert wird.

5. Verfahren nach einem der vorhergehenden Ansprüche, **dadurch gekennzeichnet, daß** die Eiskristalle schräg auf das Substrat gerichtet werden.

6. Verfahren nach einem der vorhergehenden Ansprüche, **dadurch gekennzeichnet, daß** die Eiskristalle in wenigstens einer Eis-Düse erzeugt werden, die auf das Substrat gerichtet ist.

7. Verfahren nach Anspruch 6, **dadurch gekennzeichnet, daß** während der Reinigung eine Relativbewegung zwischen Eis-Düse und Substrat erzeugt wird.

8. Verfahren nach einem der Ansprüche 6 oder 7, **dadurch gekennzeichnet, daß** das Substrat und/oder die Eis-Düse linear bewegt wird.

9. Verfahren nach einem der vorhergehenden Ansprüche, **dadurch gekennzeichnet, daß** das Substrat um seine Mittelachse gedreht wird.

10. Verfahren nach einem der vorhergehenden Ansprüche, **dadurch gekennzeichnet, daß** das Substrat während der Reinigung bezüglich der Horizontalen geneigt ist.

11. Verfahren nach einem der vorhergehenden Ansprüche, **dadurch gekennzeichnet, daß** die Flüssigkeit aus deionisiertem Wasser besteht.

12. Verfahren nach einem der vorhergehenden Ansprüche, **dadurch gekennzeichnet, daß** die Eiskristalle aus CO₂ bestehen.

13. Vorrichtung (1) zum Reinigen von Substraten (2), insbesondere Halbleiterwafem, mit einer Einrichtung (4) zum Aufbringen einer Flüssigkeit auf das Substrat, und einer Einrichtung (6) zum Einleiten von Eiskristallen in die Flüssigkeit, **dadurch gekennzeichnet, daß** die Flüssigkeit eine wesentlich höhere Temperatur als die Eiskristalle besitzt und daß eine Steuereinrichtung zum Steuern der Eindringtiefe der Eiskristalle in die Flüssigkeit vorgesehen ist, die derart steuerbar ist, daß die Eiskristalle nicht auf die zu reinigende Oberfläche des Substrats auftreffen.

14. Vorrichtung nach Anspruch 13, **dadurch gekennzeichnet, daß** die Steuereinrichtung die Dicke der Flüssigkeitsschicht auf dem Substrat steuert.

15. Vorrichtung nach Anspruch 13 oder 14, **dadurch gekennzeichnet, daß** die Einrichtung zum Aufbringen der Flüssigkeit wenigstens eine Düse (4) aufweist.

16. Vorrichtung nach Anspruch 15, **dadurch gekennzeichnet, daß** die Düse (4) eine Breitschlitzdüse ist.

17. Vorrichtung nach Anspruch 15 oder 16, **dadurch gekennzeichnet, daß** die Breite der Düse (4) größer oder gleich der Breite des Substrats (2) ist.

18. Vorrichtung nach einem der Ansprüche 13 bis 17, **gekennzeichnet durch** wenigstens eine Einrichtung zum Temperieren der Flüssigkeit.

19. Vorrichtung nach einem der Ansprüche 13 bis 18, **gekennzeichnet durch** eine auf die Flüssigkeit gerichtete Eis-Düse(6).

20. Vorrichtung nach einem der Ansprüche 13 bis 19, **dadurch gekennzeichnet, daß** die Düse und/oder die Eis-Düse schräg auf die Oberfläche (8) des Substrats (2) gerichtet sind/ist.

21. Vorrichtung nach einem der Ansprüche 13 bis 20, **dadurch gekennzeichnet, daß** der Abstand zwischen dem Substrat (2) und der Düse (4) und/oder der Eis-Düse (6) steuerbar ist.

22. Vorrichtung nach einem der Ansprüche 13 bis 21, **gekennzeichnet durch** eine Bewegungseinrichtung für das Substrat (2) und/oder die Düse (4) und/oder die Eis-Düse (6).

23. Vorrichtung nach Anspruch 22, **dadurch gekennzeichnet, daß** die Bewegungseinrichtung eine Drehvorrichtung für das Substrat (2) aufweist.

24. Vorrichtung nach Anspruch 22 oder 23, **dadurch gekennzeichnet, daß** die Bewegungseinrichtung eine Linear-Bewegungseinheit (18) für das Substrat (2) und/oder die Düse (4) und/ oder die Eis-Düse (6) aufweist.

25. Vorrichtung nach einem der Ansprüche 13 bis 24, **gekennzeichnet durch** eine Kippeinrichtung (15) für das Substrat.

## Claims

1. Method of cleaning substrates, particularly semiconductor wafers, in which a liquid is applied to the substrate before and/or during the cleaning and ice crystals are introduced into the liquid disposed on the substrate, **characterised in that** the liquid has a substantially higher temperature than the ice crystals and the depth of penetration of the ice crystals into the liquid is controlled in such a manner that the ice crystals do not impinge on the surface of the substrate to be cleaned.

2. Method according to claim 1, **characterised in that** the thickness of the liquid layer is controlled.

3. Method according to claim 1 or 2, **characterised in that** the temperature of the liquid is controlled.

4. Method according to one of the preceding claims, **characterised in that** the size and/or temperature of the ice crystals is or are controlled.

5. Method according to one of the preceding claims, **characterised in that** the ice crystals are oriented obliquely onto the substrate.

6. Method according to one of the preceding claims, **characterised in that** the ice crystals are produced in at least one ice nozzle which is oriented onto the substrate.

7. Method according to claim 6, **characterised in that** a relative movement between ice nozzle and substrate is produced during the cleaning.

8. Method according to one of claims 6 and 7, **characterised in that** the substrate and/or the ice nozzle is or are moved linearly.

9. Method according to one of the preceding claims, **characterised in that** the substrate is rotated about its centre axis.

10. Method according to one of the preceding claims, **characterised in that** the substrate is inclined relative to the horizontal during the cleaning.

11. Method according to one of the preceding claims, **characterised in that** the liquid consists of deionised water.

12. Method according to one of the preceding claims, **characterised in that** the ice crystals consist of CO₂.

13. Device (1) for cleaning structures (2), particularly semiconductor wafers, with equipment (4) for applying a liquid to the substrate and equipment (6) for introducing ice crystals into the liquid, **characterised in that** the liquid has a substantially higher temperature than the ice crystals and that control equipment for controlling the depth of penetration of the ice crystals into the liquid is provided, the control equipment being controllable in such a manner that the ice crystals do not impinge on the surface of the substrate to be cleaned.

14. Device according to claim 13, **characterised in that** the control equipment controls the thickness of the liquid layer on the substrate.

15. Device according to claim 13 or 14, **characterised in that** the equipment for applying the liquid comprises at least one nozzle (4).

16. Device according to claim 15, **characterised in that** the nozzle (4) is a wide slot nozzle.

17. Device according to claim 15 or 16, **characterised in that** the width of the nozzle (4) is greater than or equal to the width of the substrate (2).

18. Device according to one of claims 13 to 17, **characterised by** at least one equipment for temperature control of the liquid.

19. Device according to one of claims 13 to 18, **characterised by** an ice nozzle (6) oriented onto the liquid.

20. Device according to one of claims 13 to 19, **characterised in that** the nozzle and/or the ice nozzle is or are oriented obliquely onto the surface (8) of the substrate (2).

21. Device according to one of claims 13 to 20, **characterised in that** the spacing between the substrate (2) and the nozzle (4) and/or the ice nozzle (6) is controllable.

22. Device according to one of claims 13 to 21, **characterised by** movement equipment for the substrate (2) and/or the nozzle (4) and/or the ice nozzle (6).

23. Device according to claim 22, **characterised in that** the movement equipment comprises a rotary device for the substrate (2).

24. Device according to claim 22 or 23, **characterised in that** the movement equipment comprises a linear movement unit (18) for the substrate (2) and/or the nozzle (4) and/or the ice nozzle (6).

25. Device according to one of claims 13 to 24, **characterised by** tilting equipment (15) for the substrate.

## Revendications

1. Procédé de nettoyage de substrats, en particulier de plaquettes de semi-conducteur, dans lequel avant et/ou pendant le nettoyage, un liquide est appliqué au substrat et des cristaux de glace sont introduits dans le liquide se trouvant sur le substrat, **caractérisé en ce que** le liquide est à une température nettement plus élevée que les cristaux de glace et que la profondeur de pénétration des cristaux de glace dans le liquide est commandée de façon que les cristaux de glace ne heurtent pas la surface à nettoyer du substrat.

2. Procédé selon la revendication 1, **caractérisé en ce que** l'épaisseur d'une couche de liquide est commandée.

3. Procédé selon la revendication 1 ou 2, **caractérisé en ce que** la température du liquide est commandée.

4. Procédé selon l'une des revendications précédentes, **caractérisé en ce que** la grandeur et/ou température des cristaux de glace est commandée.

5. Procédé selon l'une des revendications précédentes, **caractérisé en ce que** les cristaux de glace sont dirigés en biais sur le substrat.

6. Procédé selon l'une des revendications précédentes, **caractérisé en ce que** les cristaux de glace sont produits dans au moins une buse de glace qui est dirigée vers le substrat.

7. Procédé selon la revendication 6, **caractérisé en ce que** pendant le nettoyage, un mouvement relatif est produit entre la buse de glace et le substrat.

8. Procédé selon l'une des revendications 6 ou 7, **caractérisé en ce que** le substrat et/ou la buse de glace sont déplacés linéairement.

9. Procédé selon l'une des revendications précédentes, **caractérisé en ce que** le substrat est amené à tourner autour de son axe médian.

10. Procédé selon l'une des revendications précédentes, **caractérisé en ce que** le substrat est incliné pendant le nettoyage relativement à l'horizontale.

11. Procédé selon l'une des revendications précédentes, **caractérisé en ce que** le liquide est constitué d'eau désionisée.

12. Procédé selon l'une des revendications précédentes, **caractérisé en ce que** les cristaux de glace sont constitués de CO₂.

13. Dispositif (1) pour le nettoyage de substrats (2), en particulier de plaquettes de semi-conducteur, avec une installation (4) pour appliquer un liquide au substrat, et une installation (6) pour introduire des cristaux de glace dans le liquide, **caractérisé en ce que** le liquide a une température nettement plus élevée que les cristaux de glace, et **en ce qu'**il est prévu une installation de commande pour commander la profondeur de pénétration des cristaux de glace dans le liquide, qui peut être commandée de façon que les cristaux de glace ne heurtent pas la surface à nettoyer du substrat.

14. Dispositif selon la revendication 13, **caractérisé en ce que** l'installation de commande commande l'épaisseur de la couche de liquide sur le substrat.

15. Dispositif selon la revendication 13 ou 14, **caractérisé en ce que** l'installation pour appliquer le liquide présente au moins une buse (4).

16. Dispositif selon la revendication 15, **caractérisé en ce que** la buse (4) est une filière plate.

17. Dispositif selon la revendication 15 ou 16, **caractérisé en ce que** la largeur de la buse (4) est plus grande ou égale à la largeur du substrat (2).

18. Dispositif selon l'une des revendications 13 à 17, **caractérisé par** au moins une installation pour la mise à température du liquide.

19. Dispositif selon l'une des revendications 13 à 18, **caractérisé par** une buse de glace (6) dirigée sur le liquide.

20. Dispositif selon l'une des revendications 13 à 19, **caractérisé en ce que** la buse et/ou la buse de glace est dirigée en biais sur la surface (8) du substrat (2).

21. Dispositif selon l'une des revendications 13 à 20, **caractérisé en ce que** l'écart entre le substrat (2) et la buse (4) et/ou la buse de glace (6) peut être commandé.

22. Dispositif selon l'une des revendications 13 à 21, **caractérisé par** une installation de déplacement du substrat (2) et/ou de la buse (4) et/ou de la buse de glace (6).

23. Dispositif selon la revendication 22, **caractérisé en ce que** l'installation de déplacement présente un dispositif de rotation pour le substrat (2).

24. Dispositif selon la revendication 22 ou 23, **caractérisé en ce que** l'installation de déplacement présente une unité de déplacement linéaire (18) pour le substrat (2) et/ou la buse (4) et/ou la buse de glace (6).

25. Dispositif selon l'une des revendications 13 à 24, **caractérisé par** une installation de basculement (15) pour le substrat.
